(19) Europäisches Patentamt
European Patent Office
Office européen des brevets

(11) EP 1 898 225 A1

(12) EUROPEAN PATENT APPLICATION
published in accordance with Art. 153(4) EPC

(43) Date of publication:
12.03.2008 Bulletin 2008/11

(51) Int Cl.:
*G01R 31/02* (2006.01)       *G01R 19/165* (2006.01)
*H02H 3/38* (2006.01)

(21) Application number: 05809694.2

(22) Date of filing: 24.11.2005

(86) International application number:
PCT/JP2005/021548

(87) International publication number:
WO 2006/134678 (21.12.2006 Gazette 2006/51)

(84) Designated Contracting States:
AT BE BG CH CY CZ DE DK EE ES FI FR GB GR
HU IE IS IT LI LT LU LV MC NL PL PT RO SE SI
SK TR

(30) Priority: 14.06.2005 JP 2005174165

(71) Applicants:
• Ohno, Takemi
  Yokohama-shi
  Kagawa 2400026 (JP)
• Kashiramoto, Yorikazu
  Nakano-ku
  Tokyo 1650024 (JP)

• Atoji, Toyotsugu
  Kawasaki-shi
  Kagawa 2140001 (JP)

(72) Inventor: MIYAZAWA, Kiyoshi
  2140001 (JP)

(74) Representative: Delumeau, François Guy et al
  Cabinet Beau de Loménie
  158 Rue de l'Université
  75340 Paris Cedex 07 (FR)

(54) SYSTEM AND METHOD FOR DETECTING LEAK CURRENT

(57) The periphery of a load circuit (6) is covered with a conductive material (7) which is electrically connected with a grounding line (N) of an electric line (3) to be measured. A leak current detecting system is provided with a connection judging apparatus (5) for judging whether a plug (1) formed on one end side of the electric line (3) is correctly connected to a receptacle, and a leak current detecting apparatus (4) for detecting a leak current (Igr) flowing in the electric line (3) due to insulation resistance to ground.

FIG.1

EP 1 898 225 A1

**Description**

TECHNICAL FIELD

The present invention relates to a leak current breaker and method for detecting a leak current from an electric circuit under testing to interrupt the leak current.

This application is based on and claims the benefit of priority from Japanese Patent Application No. 2005-174165 filed on June 14, 2005 in Japan, the content of which is incorporated herein by reference.

BACKGROUND ART

Everyday life is carried on without much awareness of electricity. Since electricity is widely used as a source of energy in various fields, such as information processing, communication, and the like, it is indispensable in modern life.

Since electrical energy is important and useful, any failure in appropriate management and use thereof may possibly result in accidents such as fires resulting from a short circuit, electrocution, etc.

For example, a leak current that may possibly cause such a serious accident is likely to be associated with poor insulation of a circuit or device through which an electric current flows.

However, checking for a leak current takes considerable time and requires a momentary interruption of the power supply, and the numerical value of electric current corresponding to poor insulation has to be measured by an insulation resistance tester.

Recently, computers have come to be widely in society. In intelligent buildings and factory automation (FA), computer systems are continuously running day and night. Such computer systems should be checked for any leak current while continuing to operate, that is, without being turned off even for a very short time.

Therefore, the present highly sophisticated information society requires maintenance of an uninterruptible power supply system. On account of this, the insulation management of circuits and devices, through which an electric current flows, has been shifted from conventional method of checking for a leak current by the insulation resistance tester with power interruption, to a leak current measurement which can be performed with no power interruption. For this insulation management, there has been proposed a variety of methods of keeping power supply during measurement of a leak current by a leak current breaker, earth leakage fire alarm or the like (as in Japanese Unexamined Patent Applications, Publication Nos. 2001-215247 and 2002-98729).

Note here that leak currents (I) include a leak current (Igc) caused by earth capacitance and a leak current (Igr) caused by an earth insulation resistance involved directly with an insulation resistance. Since the above-mentioned short circuit-caused fire arises from insulation resistance, if the leak current (Igr) alone, that arises from the insulation resistance, can accurately be detected in a circuit, it is possible to check the insulation state of the circuit and thus prevent a catastrophe such as a short circuit-caused fire or the like.

Also, a load circuit in a household electrical appliance may become a short circuit point. In a worst case scenario the household electrical appliance may catch fire leading to a serious accident. Therefore it is necessary to detect any abnormalities in the load circuit before escalation to a worst case scenario.

However, since high density parts are installed in the household electrical appliance, when leak current is measured by the insulation resistance tester or the like to locate poor insulation, the electronic circuits may possibly be influenced by a test voltage which is applied. Therefore, since it is likely that such electronic devices will functionally be damaged, many of them cannot be tested for insulation resistance.

Thus, in many cases, it is difficult to quickly detect abnormalities in the load circuit, and to notify the user.

DISCLOSURE OF THE INVENTION

Problems to be Solved by the Invention

The present invention provides a system and a method for detecting a leak current, in which a load circuit in a household electrical appliance becomes a leakage point, and when an abnormality occurs in a power supply for the load circuit, the abnormality can be quickly detected and notified to the user.

In order to solve the above problem, a system for detecting a leak current according to the present invention provides a leak current detecting device to detect a leak current that has occurred to an electric line under testing including at least one grounding wire, the electric line under testing being formed by a plug connected to a power supply unit at a one end, and a power supply terminal at the other end which supplies power to a load circuit, the circumference of which is covered with a conductive material electrically connected to the grounding wire; and a connection judging device to judge whether the plug formed at one end of the electric line under testing is connected with appropriate polarity to the power supply unit, wherein the leak current detecting device comprising: leak current detecting means for detecting a leak current flowing through the electric line under testing; converting means for converting the leak current detected by the leak current detecting means into a voltage; amplifying means for amplifying the voltage converted by the converting means; first harmonic component removing means for removing a harmonic component from the voltage amplified by the amplifying means; voltage detecting means for detecting a voltage developed on the electric line under testing; second harmonic component removing means for removing a harmonic component from the voltage detected by the voltage detecting means; phase contrast detecting means for detecting a contrast in signal waveform between the voltage from which the harmonic component has been removed by the first harmonic component removing means and the voltage from which the harmonic component has been removed by the second harmonic component removing means; frequency calculating means for calculating a frequency occurring on a voltage line on which the voltage has been detected by the voltage detecting means on the basis of the signal waveform of the voltage having the harmonic component removed by the second harmonic component removing means; phase angle calculating means for calculating a phase angle of the leak current flowing through the electric line under testing on the basis of the phase contrast detected by the phase contrast detecting means and the frequency calculated by the frequency calculating means; root-mean-square value calculating means for calculating a root-mean-square value of the voltage having the harmonic component removed by the first harmonic component removing means; earth insulation resistance-caused leak current component calculating means for calculating a leak current component, arising from an earth insulation resistance, included in the leak current flowing through the electric line under testing on the basis of the root-mean-square value calculated by the root-mean-square value calculating means and the phase angle of the leak current flowing through the electric line under testing, calculated by the phase angle calculating means; and judging means for judging whether the leak current component, arising from the earth insulation resistance, included in the leak current flowing through the electric line under testing and calculated by the earth insulation resistance-caused leak current component calculating means has exceeded an arbitrary value.

Also, in order to solve the above problems, a method for detecting a leak current according to the present invention provides a method for detecting a leak current that has occurred to an electric line under testing including at least one grounding wire, the electric line under testing being formed by a plug connected to a power supply unit at a one end, and a power supply terminal at the other end which supplies power to a load circuit, the circumference of which is covered with a conductive material electrically connected to the grounding wire, wherein the method comprising: a leak current detecting step of detecting a leak current flowing through the electric line under testing; a converting step of converting the leak current detected in the leak current detecting step into a voltage; an amplifying step of amplifying the voltage converted in the converting step; a first harmonic component removing step of removing a harmonic component from the voltage amplified in the amplifying step; a voltage detecting step of detecting a voltage developed on the electric line under testing; a second harmonic component step of removing a harmonic component from the voltage detected in the voltage detecting step; a phase-contrast detecting step of detecting a contrast in signal waveform between the voltage from which the harmonic component has been removed in the first harmonic component removing step and the voltage from which the harmonic component has been removed in the second harmonic component removing step; a frequency calculating step of calculating a frequency occurring on a voltage line on which the voltage has been detected in the voltage detecting step on the basis of the signal waveform of the voltage having the harmonic component removed in the second harmonic component removing step; a phase angle calculating step of calculating a phase angle of the leak current flowing through the electric line under testing on the basis of the phase contrast detected in the phase contrast detecting step and the frequency calculated in the frequency calculating step; a root-mean-square value calculating step of calculating a root-mean-square value of the voltage having the harmonic component removed in the first harmonic component removing step; an earth insulation resistance-caused leak current component calculating step of calculating a leak current component, arising from an earth insulation resistance, included in the leak current flowing through the electric line under testing on the basis of the root-mean-square value calculated in the root-mean-square value calculating step and the phase angle of the leak current flowing through the electric line under testing, calculated in the phase angle calculating step; and a judging step of judging whether the leak current component, arising from the earth insulation resistance, included in the leak current flowing through the electric line under testing and calculated in the earth insulation resistance-caused leak current component calculating step has exceeded an arbitrary value.

These objects and other objects, and specific advantages of the present invention will become more apparent from the following detailed description of the best mode for carrying out the present invention.

BRIEF DESCRIPTION OF THE DRAWINGS

FIG. 1 is a block diagram which shows a configuration of a leak current detecting system according to the present invention;
FIG. 2 is a block diagram which shows a configuration of a leak current sensor comprised by the leak current detecting system shown in FIG. 1;

FIGS. 3A and 3B illustrate phase contrasts between leak currents Igr and Igc when the power is single-phase and three-phase, respectively;

FIG. 4 is a figure to explain the operation of a connection judging device;

FIG. 5 is a chart which shows the state that a leak current Igr flows in the N phase of an electric line under testing from a load circuit through a leak point;

FIG. 6 is a flow chart which shows actuating of the leak current detecting system; and

FIG. 7 is a block diagram which shows the other configuration of the leak detection system according to the present invention.

## PREFERRED MODE FOR CARRYING OUT THE INVENTION

A leak current detecting system and method as an embodiment of the invention are described below.

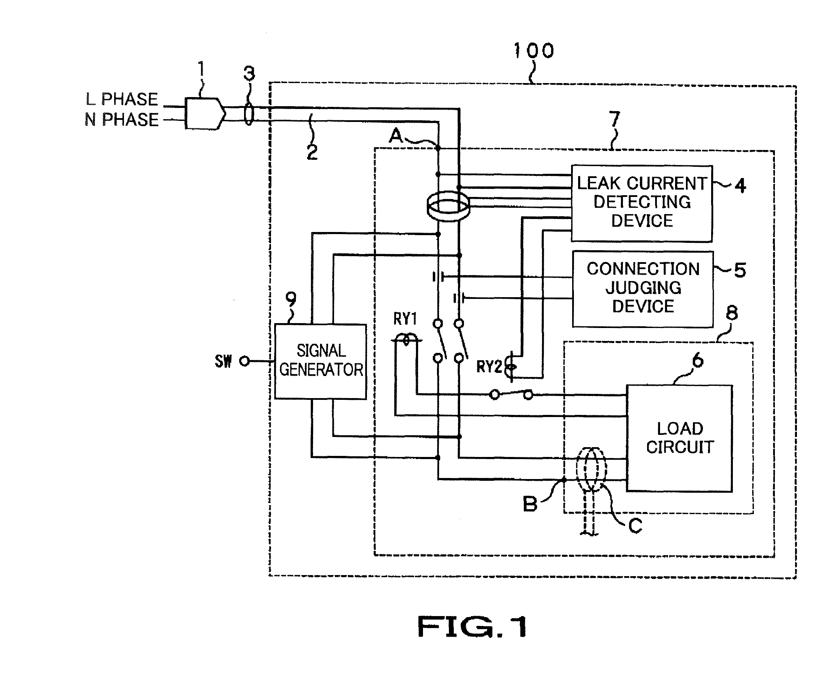

A leak current detecting system 100 comprises, as shown in FIG. 1, an electric line 3 under testing including at least one grounding wire N, the electric line 3 under testing being formed by a plug 1 connected to a power supply unit at a one end, and a power supply terminal 2 at the other end which supplies power to a predetermined load circuit 6; a leak current detecting device 4 for detecting a total leak current I flowing through electric line 3 under testing; and a connection judging device 5 for judging whether a plug 1 of the electric line 3 under testing is connected to a power supply unit (socket outlet) with appropriate polarity. Moreover, the load circuit 6 is surrounded and covered with a conductive material 7, and the conductive material 7 is electrically connected to a grounding wire N of the electric line 3 under testing. Note that, a connecting point of the conductive material 7 and the grounding wire N is hereinafter referred to as a connecting point A.

Furthermore, the conductive material 7 is arranged to include at least the load circuit 6 and a CT sensor 10 of a leak current detecting device 4 to be described later. Thus, as shown in FIG. 1, the load circuit 6 may be configured so that its surroundings are covered by the conductive material 8. In such a configuration, the conductive material 8 and the grounding wire N are connected at a connecting point B, and the CT sensor 10 is arranged at the position of B.

In addition, as shown in FIG. 1, a relay coil RY1 and a relay coil RY2, which are configured with a trip coil TC, are arranged to the electric line 3 under testing. Note that the relay coil RY2 is usually in the closed (shut) state.

Moreover, the leak current detecting system 100 according to the present invention is built in, for example, household electrical appliances such as a television, an audio system, a refrigerator, a washer and the like. When a leak point occurs in the load circuit inside such a household electrical appliance, the leak current detecting system 100 detects a leak current Igr due to the leak point, and performs various kinds of operations depending on the detected value.

The leak current detecting system 100 functions as will be explained below. In the leak current detecting system 100, after the plug 1 is connected to a socket outlet, and SW is pressed, an ON signal is supplied from a signal generator 9 to the load circuit 6. The load circuit 6 closes the relay coil RY1 in response to the supplied ON signal.

When the relay coil RY1 is closed, power is supplied to the load circuit 6 via the electric line 3 under testing. Moreover, when SW is pressed in a state where power is supplied to the load circuit 6, a signal generator 9 supplies an OFF signal to the load circuit 6. The load circuit 6 opens the relay coil RY1 in response to the supplied OFF signal. In the load circuit 6, when the relay coil RY1 is opened, the power is cut off.

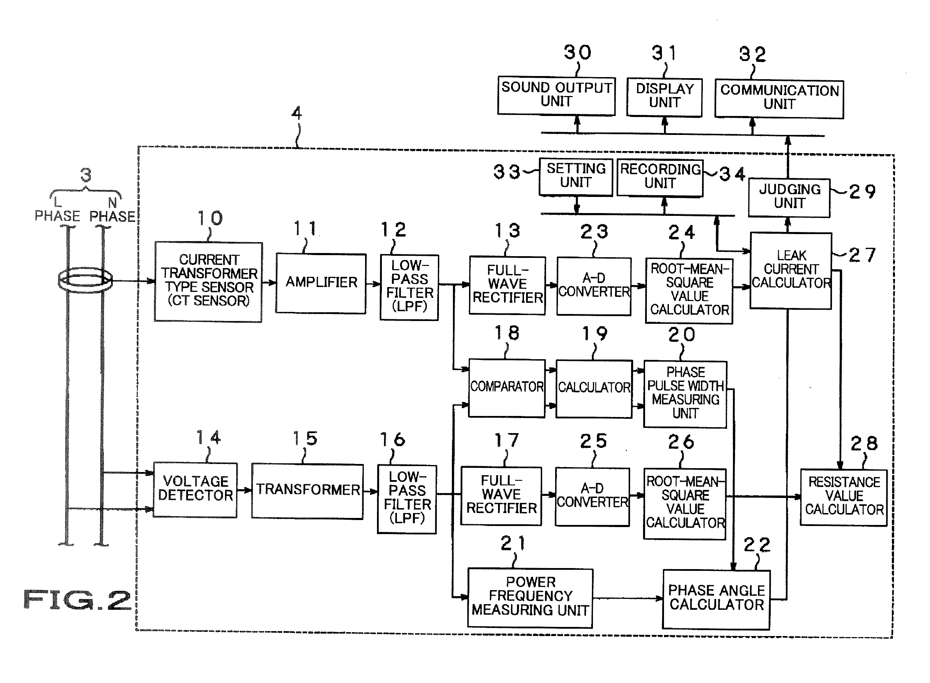

Next, a configuration and operations of the leak current detecting device 4 are explained with reference to FIG. 2.

The leak current detecting device 4 includes a current transformer type sensor (hereinafter referred to as "CT sensor") 10 clamped to the entire electric line 3 under testing to detect a total leak current I flowing through the electric line 3 under testing; an amplifier 11 to convert the total leak current I detected by the CT sensor 10 into a voltage and amplify the voltage V1 resulting from the conversion (hereinafter referred to as "converted voltage"); a low-pass filter (hereinafter referred to as "LPF") 12 to remove a harmonic component from the converted voltage V1 after amplification; a full-wave rectifier 13 to rectify the converted voltage V1 having the harmonic component removed by the LPF 12; a voltage detector 14 to detect a voltage V2 from the electric line 3 under testing; a transformer 15 to change the voltage V2 detected by the voltage detector 14 to a predetermined transformation ratio; a low-pass filter (hereinafter referred to as "LPF") 16 to remove a harmonic component from the voltage V2 changed by the transformer 15 to have a predetermined value; full-wave rectifier 17 to rectify the voltage V2 from which the harmonic component has been removed by the LPF 16; a comparator 18 to make a comparison between a signal waveform S1 of the converted voltage V1 having the harmonic component removed by the LPF 12 and a signal waveform S2 of the voltage V2 having the harmonic component removed by the LPF 16; a calculator 19 to make a predetermined calculation on the basis of the result of comparison by the comparator 18; a phase pulse width measuring unit 20 to measure the phase pulse width on the basis of the result of calculation by the calculator 19; a power frequency measuring unit 21 to measure a power frequency occurring on the voltage line included in the electric line 3 under testing from a signal indicative of the voltage V2 having the harmonic component removed by the LPF 16; a phase angle calculator 22 to calculate the phase angle of the total leak current I flowing through the electric line 3 under testing from the phase pulse width measured by the phase pulse width measuring unit 20 and power frequency measured by the power frequency measuring unit 21; an A-D converter 23 to convert the converted voltage V1 rectified by the full-wave rectifier 13 into a digital signal; a root-mean-square value calculator 24 to calculate the root-mean-square value of the converted voltage V1 converted by the A-D converter 23 into the digital signal; an A-D converter 25 to convert the voltage V2 rectified by the full-wave rectifier 17 into a digital signal; a root-mean-square value calculator 26 to calculate the root-mean-square value of the voltage V2 converted by the A-D converter 25 into the digital signal; a leak current calculator 27 to calculate a leak current Igr arising from an earth insulation resistance from the phase angle of the total leak current I calculated by the phase angle calculator 22 and root-mean-square value of the converted voltage V1 calculated by the root-mean-square value calculator 24; a resistance value calculator 28 to calculate a resistance value of the earth insulation resistance from the phase angle of the total leak current I calculated by the phase angle calculator 22 and the root-mean-square value of the voltage V2 calculated by the root-mean-square value calculator 26; and a judging unit 29 to judge whether the leak current Igr calculated by the leak current calculator 27 exceeds an arbitrary value.

The CT sensor 10 detects magnetism arising from a leak current component flowing through the electric line 3 under testing and generates a current from the detected magnetism. The CT sensor 10 supplies the amplifier 11 with the current thus produced as a total leak current I. It should be noted that the total leak current I produced by the CT sensor 10 comprises a leak current Igc arising from an earth capacitance, and a leak current Igr arising from an earth insulation resistance involved directly with an insulation resistance. It should also be noted that the leak current Igc will increase corresponding to the length of the electric line 3 and will also increase due to a harmonic distortion current arising from an inverter, noise filter and the like, included in an electric device.

The amplifier 11 converts the total leak current I supplied from the CT sensor 10 into a voltage and amplifies the converted voltage V1 up to a predetermined level. Also, in cases where the total leak current I supplied from the CT sensor 10 is from 0 to 10 mA, the amplifier 11 amplifies the converted voltage V1 in two steps. In cases where the leak current I supplied from the CT sensor 10 is from 10 to 300 mA, the amplifier 11 amplifies the converted voltage V1 in a single step. The amplifier 11 supplies the converted voltage V1 after amplification to the LPF 12. The LPF 12 removes (filters out) a harmonic component from the converted voltage V1. The LPF 12 supplies the converted voltage V1 having the harmonic component thus removed, to the full-wave rectifier 13 and comparator 18. The full-wave rectifier 13 rectifies the supplied converted voltage V1, and supplies the converted voltage V1 thus rectified to the A-D converter 23.

The voltage detector 14 has a voltage probe thereof connected to the electric line 3 under testing to detect a voltage developed on the electric line 3 under testing (between N phase (grounding wire) and L phase). It should be noted that in cases where the electric line 3 under testing is of a three-phase three-wire system (delta connection type), the voltage detector 14 detects a voltage between R and T phases, outside of S phase (grounding). Also, in cases where the electric line 3 under testing is of a three-phase four-wire system (star connection type), the voltage detector 14 detects a voltage between phases, outside of the grounding wire. Also, in cases where the electric line 3 under testing is of a single-phase three-wire system, the voltage detector 14 detects a voltage between N and L phases, outside of the grounding wire.

The voltage detector 14 determines a reference point from the voltage V2 detected from the electric line 3 under testing and supplies the voltage V2 to the transformer 15. For example, the voltage detector 14 determines, as the reference point, a point where the voltage V2 detected from the electric line 3 under testing crosses zero (zero-cross point).

The transformer 15 changes the supplied voltage V2 into a voltage of a predetermined value, and supplies the transformed voltage V to the LPF 16. The transformer 15 changes the voltage V2 to a transformation ratio of 20:1, for example. The LPF 16 removes a harmonic component from the supplied voltage V2. The LPF 16 supplies the voltage V2 having the harmonic component removed to the full-wave rectifier 17, comparator 18 and power frequency measuring unit 21. The full-wave rectifier 17 rectifies the supplied voltage V2 and supplies the rectified voltage V2 to the A-D converter 25.

The comparator 18 takes a zero-cross point of the converted voltage V1 supplied from the LPF 12 and converts the voltage V1 into a signal having a square wave, and supplies the square-wave signal to the calculator 19. Also, the comparator 18 takes zero-cross point of the voltage V2 supplied from the LPF 16 and converts it into a signal having a square wave, and supplies the square-wave signal to the calculator 19.

The calculator 19 makes a predetermined calculation on the basis of the signal supplied from the comparator 18 and supplies the calculated signal to the phase pulse width measuring unit 20. The calculator 19 is, for example, an EXOR (exclusive OR) circuit to make EXOR calculation of two square-wave signals from the comparator 18.

The phase pulse width measuring unit 20 detects phase pulse widths of the converted voltages V1 and V2 on the basis of the result of calculation from the calculator 19. The phase pulse width measuring unit 20 functions as will be explained below.

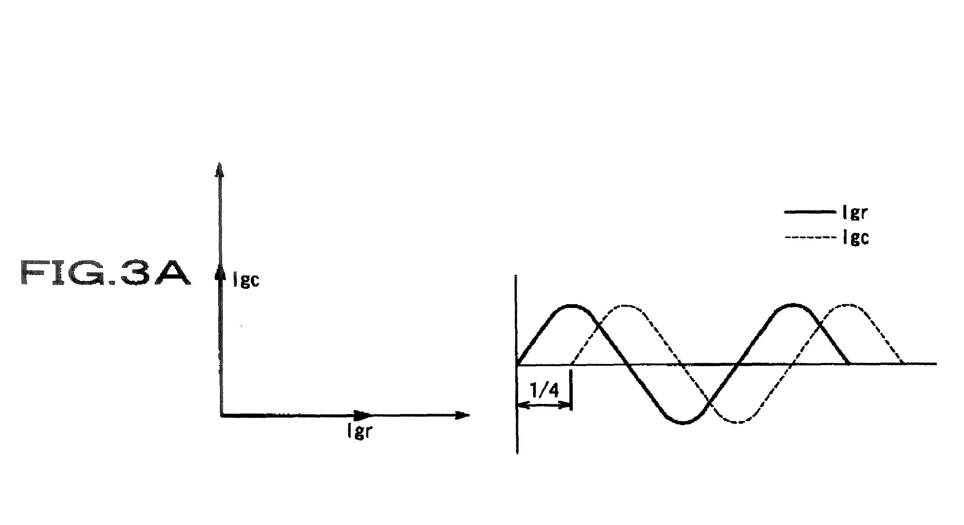

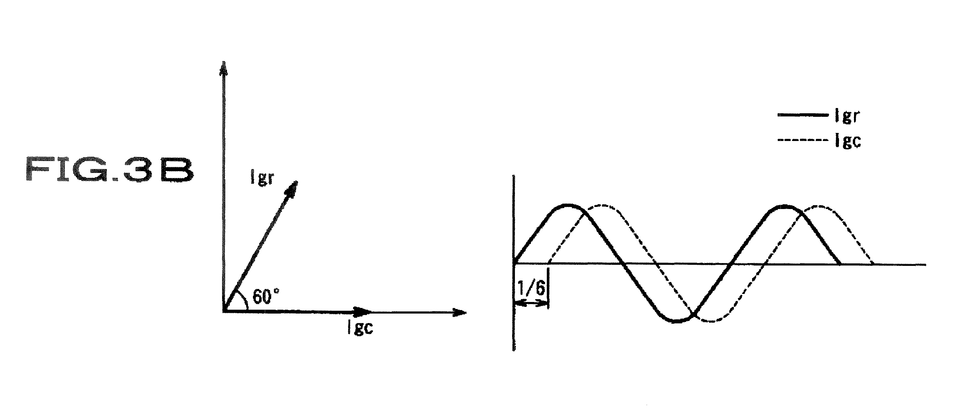

In cases where the power system is of a single-phase system, the phase angle $\theta$ of the leak current Igr is 0 deg. and phase angle $\theta$ of the leak current Igc is 90 deg. as shown in FIG. 3A. Therefore, the phase contrast between the leak currents Igr and Igc is 90 deg. (1/4 cycle). Also, in cases where the power is three-phase, the phase angle $\theta$ of

the leak current Igr is 60 deg. and phase angle θ of the leak current Igc is 0 deg. as shown in FIG. 3B. Therefore, the phase contrast between the leak currents Igr and Igc is 60 deg. (1/6 cycle). Thus, the phase pulse width measuring unit 20 is applicable to a phase pulse width of 1/4 or less of one cycle so that it can measure a phase pulse width whether the power is a single-phase or three-phase one.

Therefore, the phase pulse width measuring unit 20 supplies the phase angle calculator 22 with a phase pulse width of less than 1/4 of one cycle, calculated based on the result of calculation from the calculator 19. It should be noted that in cases where the power frequency is 60 Hz, one cycle is 16.6 ms and thus the phase pulse width is 4.15 ms or less, and that in cases where the power frequency is 50 Hz, one cycle is 20 ms and thus the phase pulse width is 5 ms or less.

The power frequency measuring unit 21 measures a power frequency on the basis of the voltage V2 supplied from the LPF 16, and supplies the result of measurement to the phase angle calculator 22. It should be noted that in cases where the electric line 3 under testing is intended for a commercial power system, the result of measurement from the power frequency measuring unit 21 is 50 or 60 Hz. Also, the power frequency measuring unit 21 may be adapted to judge, based on the voltage V2 supplied from the LPF 16, whether the power frequency is 50 or 60 Hz.

The phase angle calculator 22 calculates, by equation (1) given below, the phase angle θ of the total leak current I flowing through the electric line 3 under testing on the basis of a phase pulse width W supplied from the phase pulse width measuring unit 20 and power frequency F supplied from the power frequency measuring unit 21:

$$\theta = 360 \times W / F \qquad\qquad (1)$$

The phase angle calculator 22 supplies the calculated phase angle θ to the leak current calculator 27. The A-D converter 23 converts the converted voltage V1 supplied from the full-wave rectifier 13 into a digital signal and supplies the digital signal to the root-mean-square value calculator 24. This root-mean-square value calculator 24 calculates, by equation (2) given below, a root-mean-square value $I_0$ of the converted voltage V1 on the basis of the signal supplied from the A-D converter 23. It should be noted that the signal supplied to the root-mean-square value calculator 24 is taken as $I_0$ for convenience of explanation because it is based on the converted voltage V1 resulting from conversion of the total leak current I flowing through the electric line 3 under testing.

$$I_0 = I \times (\pi / 2) / \sqrt{2} \qquad\qquad (2)$$

The root-mean-square value calculator 24 supplies the calculated root-mean-square value $I_0$ to the leak current calculator 27.

Also, the A-D converter 25 converts the rectified voltage V2 supplied from the full-wave rectifier 17 into a digital signal, and supplies the digital signal to the root-mean-square value calculator 26. This root-mean-square value calculator 26 calculates, by equation (3) given below, a root-mean-square value $V_0$ of the voltage V2 on the basis of the signal supplied from the A-D converter 25:

$$V_0 = V \times (\pi / 2) / \sqrt{2} \qquad\qquad (3)$$

The root-mean-square value calculator 26 supplies the calculated root-mean-square value $V_0$ to the resistance value calculator 28.

The leak current calculator 27 calculates a leak current Igr on the basis of the phase angle θ supplied from the phase angle calculator 22 and root-mean-square value $I_0$ supplied from the root-mean-square value calculator 24, and supplies the calculated leak current Igr to the resistance value calculator 28. It should be noted that in cases where the power is single-phase, the leak current Igr is to be calculated using equation (4) given below, and that in cases where the power is three-phase, the leak current Igr is to be calculated using equation (5) given below:

$$Igr = I_0 \times \cos \theta \qquad\qquad (4)$$

$$Igr = (I_0 \times \sin \theta)/\cos 30 \qquad (5)$$

Note that the leak current calculator 27 judges, based on a selected position of a rotary switch, whether the power is single-phase or three-phase. The selection of this rotary switch is performed, for example, in a manufacturing phase.

The resistance value calculator 28 calculates, by equation (6) given below, a resistance Gr on the basis of the root-mean-square value $V_0$ supplied from the root-mean-square value calculator 26 and leak current Igr supplied from the leak current calculator 27:

$$Gr = V_0/Igr \qquad (6)$$

In cases where the leak current Igr calculated by the leak current calculator 27 exceeds an arbitrary value, the judging unit 29 generates a predetermined cutoff signal $S_c$ and supplies the cutoff signal $S_c$ thus generated to the relay coil RY2.

Now, operations will be explained in which the relay coils RY2 and RY1 are actuated, and the power supply is cut off. In cases where the judging unit 29 judges that the leak current Igr calculated by the leak current calculator 27 exceeds an arbitrary value, the judging unit 29 actuates the relay coil RY2 to open the connecting point connected to the relay coil RY1. This operation makes it possible to cut off the power supply to the load circuit 6.

Similar to the conventional earth leak breaker, the breaking speed is approximately 2 cycles (0.04 sec with a power frequency of 50 Hz) to 5 cycles (0.1 sec with a power frequency of 50 Hz).

Also, the leak current detecting system 100 may be configured to comprise a sound output unit 30 to output a sound (beep sound) of a predetermined level. In such a configuration, in cases where the judging unit 29 judges that the leak electric current Igr calculated by the leak current calculator 27 exceeds an arbitrary value, the judging unit 29 generates a predetermined signal and supplies the signal to the sound output unit 30. In cases where the sound output unit 30 is supplied with the predetermined signal from the judging unit 29, the sound output unit 30 outputs a sound of the predetermined level. Since a sound is output from the sound output unit 30, the user can sense the abnormality of the equipment.

Also, the leak current detecting system 100 may be configured to comprise a display unit 31 to display information. In such a configuration, in cases where the judging unit 29 judges that the leak current Igr calculated by the leak current calculator 27 exceeds an arbitrary value, the judging unit 29 controls the display unit 31 to display predetermined information. The display unit 31 displays a predetermined message in response to the control of judging unit 29. The user can know the abnormality of the household electrical appliance from the message displayed on the display unit 31. Also, for example, in cases where the leak current detecting system 100 is provided to a television, a configuration may be employed in which the predetermined message is displayed on an OSD (On-Screen Display) of the television, without providing the display unit 31.

Moreover, the leak current detecting system 100 may be configured to comprise an LED to emit light in response to a predetermined signal. In such a configuration, in cases where the judging unit 29 judges that the leak current Igr calculated by the leak current calculator 27 exceeds an arbitrary value, the judging unit 29 generates a predetermined signal and supplies the signal to the LED. The LED emits light or blinks in response to the signal supplied from judging unit 29. The user can sense the abnormality of the equipment from light emitted from the LED or blinking thereof.

Also, the leak current detecting system 100 may be configured to comprise a communication unit 32 to communicate with external equipments. In such a configuration, in cases where the judging unit 29 judges that the leak current Igr calculated by the leak current calculator 27 exceeds an arbitrary value, the judging unit 29 transmits a predetermined signal to the external equipments via the communication unit 32. An operator of the external equipments can sense, based upon the received signal, the abnormality of the equipment to which the leak current detecting system 100 is provided, and can make an appropriate advice to the owner (user) of the equipment.

Also, in the present invention, it is necessary that the plug 1 of the electric line 3 under testing is connected with correct polarity to the wall socket (socket outlet) of the power supply unit. Configuration and operation of the connection judging device 5 will now be explained.

After the plug 1 is connected to the socket outlet, the connection judging device 5 reads a signal (current) flowing to N phase and , or L phase of the electric line 3 under testing, and judges whether or not the polarity is correct. In cases where the connection judging device 5 judges that the polarity is not correct, the connection judging device 5 actuates the relay coil RY2 to open the connecting point connected to the relay coil RY1. This operation makes it possible to cut off the power supply to the load circuit 6. Also, at this time, a configuration may be employed in which an alarm sound is given to the user in order to request the user to unplug and plug the plug 1 again in a different way to the socket outlet so that the polarity becomes correct.

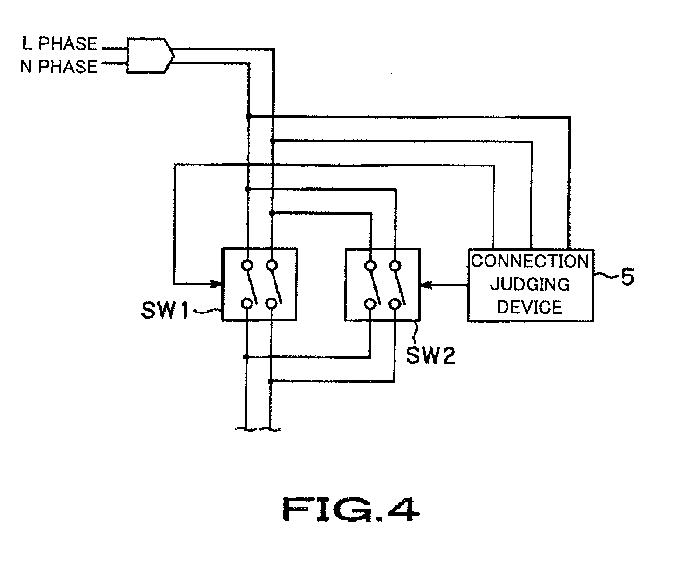

Moreover, in cases where the connection judging device 5 judges that the polarity is not correct, the situation may also be handled with other methods, instead of the method to cut off the power supply to the load circuit 6. For example, the connection judging device 5 may be configured as follows (as shown in FIG. 4): in cases where the connection judging device 5 judges that the polarity is correct, the connection judging device 5 controls switches SW1 and SW2 so that the switch SW1 is turned on and the switch SW2 is turned off; and in cases where the connection judging device 5 judges that the polarity is not correct, the connection judging device 5 controls the switches SW1 and SW2 so that the switch SW1 is turned off and the switch SW2 is turned on. This configuration eliminates the necessity to unplug and plug the plug 1 again even in cases where the polarity is not correct.

Operation of the leak current detecting system 100 will now be described for cases where a leak occurs at a leak point (point X) of the load circuit 6. After the leak current detecting system 100 confirmed, by the connection judging device 5, that the plug 1 is connected to the socket outlet with correct polarity, the leak current detecting system 100 monitors, by a leak current detecting device 4, whether or not the leak current Igr occurs to the electric line 3 under testing.

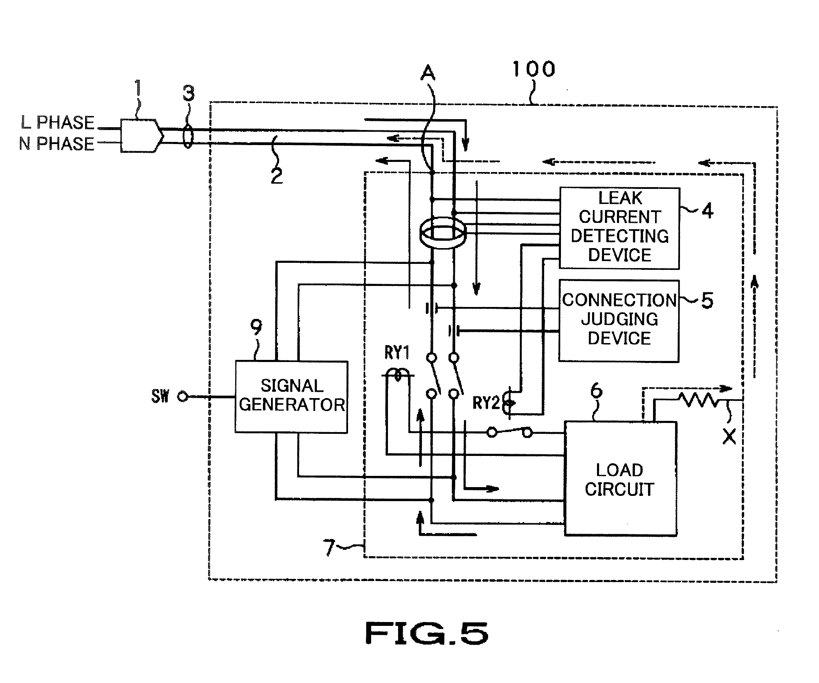

For example, as shown in FIG. 5, in cases where a leak occurs at the leak point (point X) of the load circuit 6, the leak current Igr flows along the conductive material '7, passes the connecting point A, and flows into N phase. When the leak current Igr flows from the connecting point A into N phase, a change occurs in a current difference between L phase and N phase of a load current passing the CT sensor 10 clamping the electric line 3 under testing. The leak current detecting device 4 accurately detects this change (leak current Igr), and judges whether or not the detected value exceeds an arbitrary value. Note that, in FIG. 5, a current before the leak current Igr occurs is shown by a solid line with an arrow, and the leak current Igr is shown by a dotted line with an arrow.

Also, the leak current detecting device 4 may include a setting unit 33 to set an arbitrary value, and may be configured such that the judging unit 29 judges whether or not the leak current Igr calculated by the leak current calculator 27 has exceeded an arbitrary value set by the setting unit 33. In this case, the setting unit 33 may be adapted to select a plurality of preset values by means of a rotary switch. Also, the values are set in steps of 10 mA. For example, the selection of this rotary switch is performed in a manufacturing phase.

Also, the leak current detecting device 4 may include a recording unit 34 to record the leak current Igr calculated by the leak current calculator 27. Since the recording unit 34 records the leak current Igr calculated by the leak current calculator 27 at each elapsed time interval, it is possible to know how the leak current Igr changes as time proceeds.

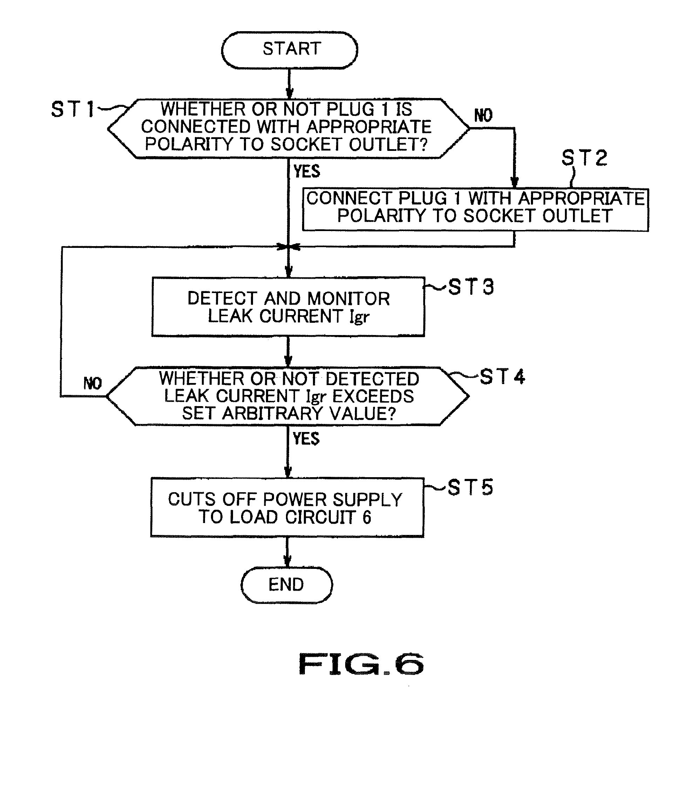

Operations of the leak current detecting system 100 according to the present invention will now be described with reference to the flow chart shown of FIG. 6.

In step ST1, the connection judging device 5 judges whether or not the plug 1 is connected with appropriate polarity to the socket outlet. If the plug 1 is not connected with appropriate polarity to the socket outlet, the process proceeds to step ST2; and if the plug 1 is connected with appropriate polarity to the socket outlet, the process proceeds to step ST3.

In step ST2, the connection judging device 5 performs a predetermined operation so that the plug 1 is connected with appropriate polarity to the socket outlet. As for the predetermined operation in this process, as described above, a configuration may be employed in which the power supply to the load circuit 6 is cut off, and an alarm sound is given to the user in order to request the user to unplug and plug the plug 1 again in a different way, or a configuration may be employed in which the polarity is automatically reversed.

In step ST3, the leak current detecting device 4 monitors whether or not the leak current Igr occurs to the electric line 3 under testing.

In step ST4, if the leak current detecting device 4 detects the leak current Igr, the leak current detecting device 4 judges whether or not the detected leak current Igr exceeds a set arbitrary value. If the detected leak current Igr does not exceed the set arbitrary value, the process goes back to step ST3 to continue the monitoring of the leak current Igr. If the detected leak current Igr exceeds the set arbitrary value, the process proceeds to step ST5.

In step ST5, the leak current detecting device 4 cuts off the power supply to the load circuit 6. Note that, in this process, as described above, for example, a configuration may be employed in which if the leak current detecting device 4 judges that the leak current Igr exceeds an arbitrary value, a predetermined display is performed on the display unit 31 in order to notify the user of the abnormality of the equipment.

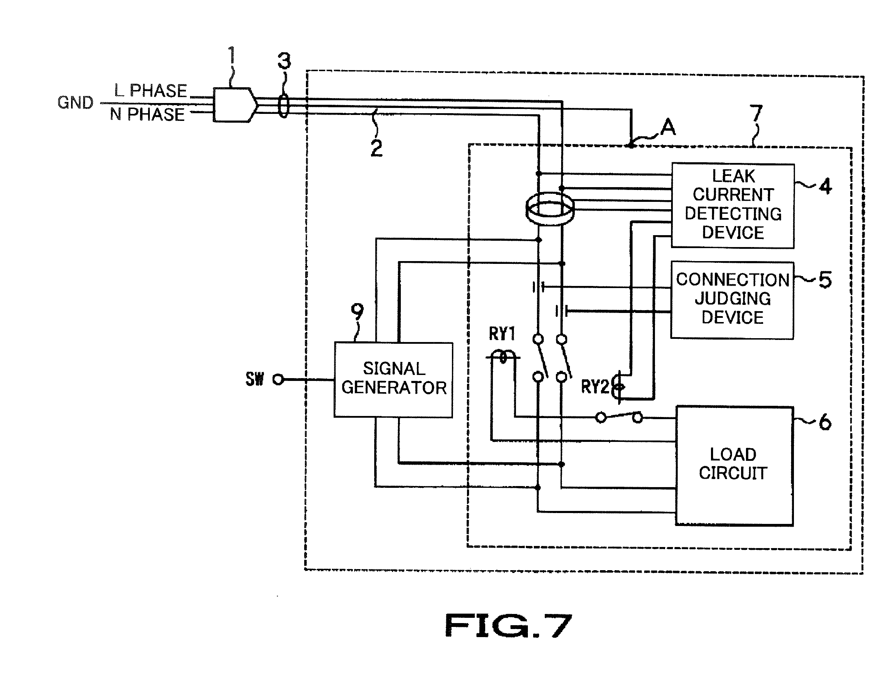

Also, as shown in FIG. 7, in cases where the plug 1 is of a 3P type, the leak current detecting system 100 is configured such that a GND line is electrically connected to the conductive material 7.

In the leak current detecting system 100 thus configured according to the present invention, the circumference of the load circuit 6 is covered by the conductive material 7 that is electrically connected to the grounding wire N of the electric line 3 under testing. In addition, provided are the connection judging device 5 to judge whether or not the plug 1 formed at one end of the electric line 3 under testing is appropriately connected to the socket outlet, and the leak current detecting device 4 to accurately detect the leak current Igr caused by an earth insulation resistance, the leak current flowing through the electric line 3 under testing. This makes it possible to accurately detect the leak current Igr caused at the leak point of the load circuit 6. This also makes it possible to avoid serious accidents by taking an appropriate response depending on the detected value.

For example, in cases where the leak current detecting system 100 according to the present invention is applied to electric appliances such as a television, a refrigerator, a PC or the like, the circumference of an arbitrary load circuit in an electric appliance is surrounded by the conductive material 7, the grounding wire N of the conductive material 7 and the electric line 3 under testing is electrically connected, and the electric line 3 under testing is clamped with the CT sensor 10. By doing this, a leak current Igr due to the leak point (earth insulation resistance) of the load circuit is monitored and detected, and a predetermined operation is performed depending upon the detected value of the leak current Igr. Accordingly, it is possible to discover abnormalities of the electric appliances in an early stage, and to take an appropriate response to the electric appliances before a serious accident occurs.

Also, since the leak current detecting device 4 according to the present invention determines a reference point from a voltage developed on transmission lines without using any existing reference point as in the frequency infusion method, it can accurately measure a leak current Igr flowing through the electric line 3 under testing.

It is a matter of course that the present invention is not limited to the foregoing embodiments as described with reference to the drawings, and that various changes, replacements or the like can be done without departing from the scope and spirit of the appended claims.

INDUSTRIAL APPLICABILITY

In the present invention, the circumference of the load circuit is covered by the conductive material that is electrically connected to the grounding wire N of the electric line under testing. In addition, provided are the connection judging device to judge whether or not the plug formed at one end of the electric line under testing is appropriately connected to the socket outlet, and the leak current sensor to accurately detect the leak current Igr caused by an earth insulation resistance, the leak current flowing through the electric line under testing. This makes it possible to accurately detect the leak current Igr caused at the leak point of the load circuit. This also makes it possible to avoid serious accidents by taking an appropriate response depending on the detected value.

**Claims**

1. A leak current detecting system, comprising:

a leak current detecting device to detect a leak current that has occurred to an electric line under testing including at least one grounding wire, the electric line under testing being formed by a plug connected to a power supply unit at a one end, and a power supply terminal at the other end which supplies power to a load circuit, the circumference of which is covered with a conductive material electrically connected to the at least one grounding wire; and
a connection judging device to judge whether the plug formed at the one end of the electric line under testing is connected with appropriate polarity to the power supply unit,

wherein the leak current detecting device comprises:

leak current detecting means for detecting a leak current flowing through the electric line under testing;
converting means for converting the leak current detected by the leak current detecting means into a voltage;
amplifying means for amplifying the voltage converted by the converting means;
first harmonic component removing means for removing a harmonic component from the voltage amplified by the amplifying means;
voltage detecting means for detecting a voltage developed on the electric line under testing;
second harmonic component removing means for removing a harmonic component from the voltage detected by the voltage detecting means;
phase contrast detecting means for detecting a contrast in signal waveform between the voltage from which the harmonic component has been removed by the first harmonic component removing means and the voltage from which the harmonic component has been removed by the second harmonic component removing means;
frequency calculating means for calculating a frequency occurring on a voltage line on which the voltage has been detected by the voltage detecting means based on the signal waveform of the voltage having the harmonic component removed by the second harmonic component removing means;
phase angle calculating means for calculating a phase angle of the leak current flowing through the electric line under testing based on the phase contrast detected by the phase contrast detecting means and the frequency calculated by the frequency calculating means;

root-mean-square value calculating means for calculating a root-mean-square value of the voltage having the harmonic component removed by the first harmonic component removing means;

earth insulation resistance-caused leak current component calculating means for calculating a leak current component, arising from an earth insulation resistance, included in the leak current flowing through the electric line under testing based on the root-mean-square value calculated by the root-mean-square value calculating means and the phase angle of the leak current flowing through the electric line under testing, calculated by the phase angle calculating means; and

judging means for judging whether the leak current component, arising from the earth insulation resistance, included in the leak current flowing through the electric line under testing and calculated by the earth insulation resistance-caused leak current component calculating means has exceeded an arbitrary value.

2. The leak current detecting system according to claim 1, further comprising a cutoff unit to cut off power supplied from the power supply terminal to the load circuit,
wherein the judging means controls the cutoff unit to cut off power supplied from the power supply terminal to the load circuit, in cases where the judging means judges that the leak current component, arising from the earth insulation resistance, included in the leak current flowing through the electric line under testing and calculated by the earth insulation resistance-caused leak current component calculating means has exceeded an arbitrary value.

3. The leak current detecting system according to claim 2, wherein the connection judging device controls the cutoff unit to cut off power supplied from the power supply terminal to the load circuit, in cases where the connection judging device judges that the plug is not connected with correct polarity to the power supply unit.

4. The leak current detecting system according to claim 1, further comprising a sound output unit to output a sound of a predetermined level,
wherein the judging means controls the sound output unit to output a sound, in cases where the judging means judges that the leak current component, arising from the earth insulation resistance, included in the leak current flowing through the electric line under testing and calculated by the earth insulation resistance-caused leak current component calculating means has exceeded an arbitrary value.

5. The leak current detecting system according to claim 4, wherein the connection judging device controls the sound output unit to output a sound, in cases where the connection judging device judges that the plug is not connected with correct polarity to the power supply unit.

6. The leak current detecting system according to claim 1, further comprising a display means to display information,
wherein the judging means controls the display means to display information, in cases where the judging means judges that the leak current component, arising from the earth insulation resistance, included in the leak current flowing through the electric line under testing and calculated by the earth insulation resistance-caused leak current component calculating means has exceeded an arbitrary value.

7. The leak current detecting system according to claim 1, further comprising a communication unit to communicate with external equipment,
wherein the judging means transmits a predetermined signal to the communication unit, in cases where the judging means judges that the leak current component, arising from the earth insulation resistance, included in the leak current flowing through the electric line under testing and calculated by the earth insulation resistance-caused leak current component calculating means has exceeded an arbitrary value.

8. The leak current detecting system according to claim 1, further comprising setting means for setting the arbitrary value.

9. The leak current detecting system according to claim 1, wherein in cases where the connection judging device judges that the plug is not connected with correct polarity to the power supply unit, the connection judging device reverses the polarity to the correct polarity.

10. The leak current detecting system according to claim 1, further comprising recording means for recording the leak current component calculated by the earth insulation resistance-caused leak current component calculating means.

11. The leak current detecting system according to claim 1, wherein the leak current detecting means detects a leak current flowing through the electric line under testing, by clamping the electric line under testing including a grounding line.

12. A method for detecting a leak current that has occurred to an electric line under testing including at least one grounding wire, the electric line under testing being formed by a plug connected to a power supply unit at a one end, and a power supply terminal at the other end which supplies power to a load circuit, the circumference of which is covered with a conductive material electrically connected to the grounding wire, wherein the method comprises:

a leak current detecting step of detecting a leak current flowing through the electric line under testing;

a converting step of converting the leak current detected in the leak current detecting step into a voltage;

an amplifying step of amplifying the voltage converted in the converting step;

a first harmonic component removing step of removing a harmonic component from the voltage amplified in the amplifying step;

a voltage detecting step of detecting a voltage developed on the electric line under testing;

a second harmonic component removing step of removing a harmonic component from the voltage detected in the voltage detecting step;

a phase-contrast detecting step of detecting a contrast in signal waveform between the voltage from which the harmonic component has been removed in the first harmonic component removing step and the voltage from which the harmonic component has been removed in the second harmonic component removing step;

a frequency calculating step of calculating a frequency occurring on a voltage line on which the voltage has been detected in the voltage detecting step based on the signal waveform of the voltage having the harmonic component removed in the second harmonic component removing step;

a phase angle calculating step of calculating a phase angle of the leak current flowing through the electric line under testing based on the phase contrast detected in the phase contrast detecting step and the frequency calculated in the frequency calculating step;

a root-mean-square value calculating step of calculating a root-mean-square value of the voltage having the harmonic component removed in the first harmonic component removing step;

an earth insulation resistance-caused leak current component calculating step of calculating a leak current component, arising from an earth insulation resistance, included in the leak current flowing through the electric line under testing based on the root-mean-square value calculated in the root-mean-square value calculating step and the phase angle of the leak current flowing through the electric line under testing, calculated in the phase angle calculating step; and

a judging step of judging whether the leak current component, arising from the earth insulation resistance, included in the leak current flowing through the electric line under testing and calculated in the earth insulation resistance-caused leak current component calculating step has exceeded an arbitrary value.

FIG.1

EP 1 898 225 A1

EP 1 898 225 A1

FIG.2

FIG.3A

FIG.3B

**FIG.4**

FIG.5

START

ST1 — WHETHER OR NOT PLUG 1 IS CONNECTED WITH APPROPRIATE POLARITY TO SOCKET OUTLET?

NO

ST2

YES

CONNECT PLUG 1 WITH APPROPRIATE POLARITY TO SOCKET OUTLET

DETECT AND MONITOR LEAK CURRENT Igr — ST3

NO — WHETHER OR NOT DETECTED LEAK CURRENT Igr EXCEEDS SET ARBITRARY VALUE? — ST4

YES

CUTS OFF POWER SUPPLY TO LOAD CIRCUIT 6 — ST5

END

# FIG.6

**FIG.7**

EP 1 898 225 A1

## INTERNATIONAL SEARCH REPORT

| | International application No. |
|---|---|
| | PCT/JP2005/021548 |

A. CLASSIFICATION OF SUBJECT MATTER
*G01R31/02*(2006.01), *G01R19/165*(2006.01), *H02H3/38*(2006.01)

According to International Patent Classification (IPC) or to both national classification and IPC

B. FIELDS SEARCHED

Minimum documentation searched (classification system followed by classification symbols)
G01R31/02-31/06

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho    1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2001-346327 A  (Matsushita Electric Works, Ltd.),<br>14 December, 2001 (14.12.01),<br>Full text; all drawings<br>(Family: none) | 1-12 |
| Y | JP 2005-140532 A  (Toyoji AHEI),<br>02 June, 2005 (02.06.05),<br>Full text; all drawings<br>(Family: none) | 1-12 |
| Y | JP 1-144322 A  (Toshiba Corp.),<br>06 June, 1989 (06.06.89),<br>Full text; all drawings<br>(Family: none) | 3,5 |

[X] Further documents are listed in the continuation of Box C.          [ ] See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>21 February, 2006 (21.02.06) | Date of mailing of the international search report<br>28 February, 2006 (28.02.06) |
|---|---|
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2005/021548 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | JP 2004-184346 A  (Hitachi Industrial Equipment System Co., Ltd.), 02 July, 2004 (02.07.04), Par. No. [0021] (Family: none) | 4-8,10 |

Form PCT/ISA/210 (continuation of second sheet) (April 2005)

**REFERENCES CITED IN THE DESCRIPTION**

**Patent documents cited in the description**

- JP 2005174165 A
- JP 2001215247 A
- JP 2002098729 A